# EUROPEAN PATENT APPLICATION

(11) **EP 4 576 190 A1**
(43) Date of publication of application: **25.06.2025**
(21) Application number: 23220041.0
(22) Date of filing: 22.12.2023
(51) Int. Cl.: H01L 21/822, H01L 21/8234, H01L 27/06, H01L 27/088, H01L 29/66, H01L 29/06, H01L 29/10, H01L 29/775

(54) **A METHOD FOR FORMING A SEMICONDUCTOR STRUCTURE**

(71) Applicant: Imec VZW, 3001 Leuven (BE)
(72) Inventor: WOSTYN, Kurt, 3210 Lubbeek (BE); ONIKI, Yusuke, 3000 Leuven (BE)
(74) Representative: AWA Sweden AB

(57) **Abstract**

The present invention provides a method for forming a semiconductor structure (100), the method comprising: forming a layer stack (110) on a substrate (102), the layer stack (110) comprising: a first sub-stack; a second sub-stack (130) on the first sub-stack (120) and comprising a plurality of sacrificial layers alternating between first and second sacrificial layers (132a, 132b), wherein neighboring first and second sacrificial layers (132a, 132b) of the second sub-stack (130) are separated by a liner layer (133); a third sub-stack (140) on the second sub-stack (130); forming recesses (160) in the layer stack; forming inner spacers (162) in the recesses (160); removing the at least one second sacrificial layer (132b) of the second sub-stack (130) by etching, thereby forming at least one first cavity (135); and filling the at least one first cavity (135) with dielectric material thereby forming at least one dielectric layer (136).

## Description

### TECHNICAL FIELD

The present disclosure relates to a method for forming a semiconductor structure.

### BACKGROUND

Complementary FETs (CFETs) are currently on the scaling roadmap as one of the next generation scaling options. The CFET comprises a NFET (i.e. a N-type FET) and a PFET (i.e. a P-type FET) stacked on top of each other (or the reverse). The NFET and the PFET are separated vertically by a middle dielectric isolation (MDI) and the bottom device can also be isolated from the substrate by a bottom dielectric isolation (BDI).

### SUMMARY

It is an objective of the present inventive concept to provide an improved semiconductor structure and/or an improved production method for the same.

A further objective is to provide a semiconductor structure and/or FET with few dislocations.

A further objective is to provide a semiconductor structure and/or FET with a large degree of freedom concerning the choice of layer materials.

A further objective is to provide a method for forming a semiconductor structure having comparably less stringent etch selectivity requirements. A further objective is to provide a stable semiconductor structure. Further and alternative objectives may be understood from the following.

According to a first aspect of the invention, there is provided a method for forming a semiconductor structure, the method comprising:
forming a layer stack on a substrate, the layer stack comprising:
   a first sub-stack comprising a first sacrificial layer and on the first sacrificial layer a channel layer defining a topmost layer of the first sub-stack,
   a second sub-stack on the first sub-stack and comprising a plurality of sacrificial layers alternating between first and second sacrificial layers, wherein neighboring first and second sacrificial layers of the second sub-stack are separated by a liner layer, wherein first sacrificial layers define a respective bottommost and topmost layer of the second sub-stack, the second sub-stack comprising at least one second sacrificial layer;
   a third sub-stack on the second sub-stack and comprising a channel layer defining a bottommost layer of the third sub-stack and a first sacrificial layer on the channel layer;
   wherein the first sacrificial layers are formed of a first sacrificial semiconductor material, the second sacrificial layers are formed of a second sacrificial semiconductor material different from the first sacrificial semiconductor material, and the liner layers are formed of a semiconductor material different from the first and second sacrificial semiconductor materials;
forming source/drain recesses, the source/drain recesses exposing end surfaces of the layer stack;
forming recesses in the layer stack by laterally etching back the end surfaces of the first sacrificial layers from opposite ends of the layer stack, by selective etching;
forming inner spacers in the recesses;
removing the at least one second sacrificial layer of the second sub-stack by etching, thereby forming at least one first cavity, while first sacrificial layers of the second sub-stack are being protected from said act of etching by the inner spacers and the liner layers; and
filling the at least one first cavity with dielectric material thereby forming at least one dielectric layer.

By the wording "a first layer arranged on a second layer" in reference to any of the layers (or layers of the sub-stack) of the layer stack is hereby meant that the first layer is arranged directly on (i.e. in abutment with) the second layer.

Relative spatial terms such as "topmost", "bottom", "lower", "vertical", "stacked on top of", are herein to be understood as denoting locations or directions within a frame of reference of the semiconductor structure. In particular, the terms may be understood in relation to a normal direction to the substrate on which the layer stack is formed, or equivalently in relation to a bottom-up/stacking direction of the layer stack. Correspondingly, terms such as "lateral" and "horizontal" are to be understood as locations or directions parallel to the substrate.

The term "thickness" is to be understood as a dimension of a structure (e.g. a layer of a sub-stack) as seen along a normal to a surface underlying the structure (e.g. the layer of the sub-stack). For example, the thickness of a layer of the layer stack, or the thickness of the sub-stack, may refer to the thickness dimension of the layer/sub-stack as seen along the bottom-up/stacking direction of the layer stack.

The semiconductor structure may be a semiconductor structure for producing a stack of field effect transistors (FETs) comprising a top and bottom FET. The stack of FETs may be a CFET, wherein the top FET is a NFET and the bottom FET is a PFET, or vice versa. Thus, the semiconductor structure may be a semiconductor structure suitable to be converted into a stack of FETs, e.g. a CFET.

Accordingly, the method is compatible with Complementary FET (CFET) device fabrication. The method is also compatible with forksheet device fabrication. The resulting semiconductor structure may be used to produce a stack of FETs.

The layer stack may sometimes be referred to as a superlattice stack.

When this text refers to opposite ends of the layer stack, it can be understood that said opposite ends may be the ends where source/drain regions are to be formed. It may also be understood that said opposite ends may be opposite sides of a gate structure.

Channel layers of the first sub-stack may be channel layers for a bottom FET. Similarly, channel layers of the third sub-stack may be channel layers for a top FET. Channel layers may be Si layers.

First sacrificial layers may be layers that can be replaced with a gate stack during production of a stack of FETs.

Second sacrificial layers are layers wherein the second sacrificial material has been replaced with dielectric material during production of a stack of FETs. The dielectric material may then function as electrical isolation between the bottom and top FET. Such electrical isolation between the bottom and top FET may be referred to as middle dielectric isolation.

The liner layers may be layers resistant to the etchant used to etch the second sacrificial layers. The liner layers may be layers resistant to the etchant used to recess the first sacrificial layers. The liner layers may be thin, e.g. thinner than the first and second sacrificial layers.

As mentioned, the first and second sacrificial layers are formed of different semiconductor materials. Thus, etchants may have different etch rates for the first and second sacrificial layers. Thus, the first and second sacrificial layers may be selectively etched at different points in the production process. The channel layers, liner layers, first sacrificial layers and second sacrificial layers may all be of different materials. Alternatively, channel layers and liner layers are formed of the same material, different from the first and second sacrificial semiconductor materials. Advantageously, channel layers and liner layers are formed of Si and first and second sacrificial layers are formed of SiGe, wherein first and second sacrificial layers have different Ge composition.

Layers of different materials may be lattice mismatched. Lattice mismatch may introduce strain in the layer stack. When the strain becomes too large during epitaxial growth, relaxation may occur by e.g. formation of dislocations. Dislocations are generally disadvantageous in FETs. The invention makes it possible to avoid dislocations while at the same time providing a large degree of freedom concerning the choice of layer materials and less stringent etch selectivity requirements, as compared to conventional production methods.

By the term "inner spacers" is hereby meant dielectric layer portions formed in the recesses to cover end surfaces of the first sacrificial layers. Forming the inner spacers may comprise conformally depositing an inner spacer material layer. Forming the inner spacers may comprise subsequently etching the inner spacer material layer such that a discrete portion of the inner spacer material layer remain in each recess to form an inner spacer therein. The inner spacer material may in particular be etched using an isotropic etching process to remove inner spacer material outside the recesses. An isotropic etching process allows the inner spacer material layer to be etched at a uniform rate (at least substantially). Hence, the structures covered by the inner spacer material layer may remain covered from the etchants by the inner spacer material layer substantially until the channel layer end surfaces are exposed, wherein the etching may be stopped. The inner spacer material layer may be deposited with a thickness such that the recesses are pinched-off (i.e. closed).

By the term "conformally depositing" is hereby meant a deposition process resulting in a conformally growing layer or film. Conformal deposition may be achieved using an atomic layer deposition (ALD) process.

The provision of liner layers and inner spacers enables a number of advantages:
As the first sacrificial layers of the sub-stack are being protected from said act of etching by the inner spacers and the liner layers, formation of the at least one dielectric layer is facilitated. In order to form the at least one dielectric layer, a first cavity is formed by etching. The inner spacers and the liner layers ensure that removal of material by etching does not extend to portions of the semiconductor structure that need not be removed. For instance, when etching the second sacrificial layers, the inner spacers and the liner layers may ensure that the first sacrificial layers are not exposed to the etchant. Since the inner spacers and liner layers protect the first sacrificial layers, there is provided comparably less stringent selectivity requirements for the etch and thereby there is provided a greater degree of freedom concerning the choice of material of the first and second sacrificial layers. As such, the materials of the first and second sacrificial layers may be chosen to have a small lattice mismatch. The first and second sacrificial layers may also be chosen to have a small lattice mismatch with respect to the liner layers and the channel layers. Thus, the method enables a layer stack with reduced risk for relaxation and reduced epitaxial growth induced defects, such as e.g. dislocations. Consequently, there is provided a high quality semiconductor structure which in turn enables improved device performance.

The liner layers are particularly important as they may protect the interface between first and second sacrificial layers, during the etch of the second sacrificial layer. The liner layers may be thin, e.g. thinner than the first and second sacrificial layers. Thus, the liner layers may protect the interface between first and second sacrificial layers while at the same time contributing little or not at all to the strain in the layer stack.

To illustrate, consider a first situation where no liner layers are used. In this situation it may be necessary to use first and second sacrificial layers with very different sacrificial semiconductor material. For example, one may use SiGe layers with very different Ge composition as the respective first and second sacrificial layers. Further, it may not be possible to swap materials between the first and second sacrificial layers arbitrarily. To exemplify, if the second sacrificial layers are to be removed before the first sacrificial layers, the second sacrificial layers may need to have a higher Ge composition than the first sacrificial layers.

To further illustrate, consider a second situation where inner spacers and liner layers are used. In this situation one may use first and second sacrificial layers with very similar sacrificial semiconductor material. For example, SiGe layers with only a small difference in Ge composition as the respective first and second sacrificial layers. A reason as to why this design choice is enabled is substantiated below:
The first sacrificial layers may have a higher Ge-content than that of the second sacrificial layers. It may be envisioned that sacrificial layers having a comparably higher Ge-content are etched at a faster rate compared to sacrificial layers having a comparably lower Ge-content for a given etchant. Hence, upon subsequent etching, an etchant may etch the second sacrificial layers which have a comparably lower Ge-content than that of the first sacrificial layers. Moreover, the presence of the inner spacers and the liner layers may protect the remaining first sacrificial layers. Thereby, less stringent selectivity requirements are provided. It is further conceivable that the channel layers of the layer stack may be made of Si, which are etched little to none for said given etchant. Thus, by placing the first sacrificial layers in proximity of the channel layers (or even in abutment therewith), the channel layers may protect the first sacrificial layers in a similar manner as the inner spacers and liner layers, which further reduces the selectivity requirements, e.g. a reduced difference between high Ge-content and low Ge-content compared to conventional structures where no liner layers are used. Thus, according to the above exemplary situations, the invention provides a large degree of freedom concerning the choice of layer materials which may be used to facilitate other strain distributions in the layer stack than with conventional methods. That is, the invention allows for the employment of SiGe layers with only a small difference in Ge composition as the respective first and second sacrificial layers. It should be noted that the above situations are examples. The invention is also applicable to sacrificial semiconductor materials other than SiGe. As the liner layers and the inner spacers enable comparably less stringent selectivity requirements with respect to the layer materials of the layer stack, growth of a fully strained layer stack comprising two or more channels per device polarity is enabled. Conventional integration schemes may include layer materials wherein a large lattice mismatch is present therebetween thereby hampering the possibilities of forming a layer stack comprising several channels per device polarity. Less stringent selectivity requirements enable the formation of a layer stack comprising a plurality of channels per device polarity. For instance, a layer stack enabling two or more nanosheets per device polarity may be enabled. This enables further device scaling.

By the term "device polarity" is hereby meant the type of FET, e.g. p-type or n-type MOSFET, wherein the p-type MOSFET is of one polarity and the n-type MOSFET is of another polarity.

Although the method may advantageously be used in conjunction with forming forksheet and CFET devices, it is contemplated that the method may be used also to form other horizontal channel FET devices (e.g. nanowire FETs (NWFETs) or as discussed above, nanosheet FETs (NSHFETs)) requiring inner spacers, and which may benefit from liner layers.

By the term "layer stack" is hereby meant a structure of layers, sequentially formed on top of each other. The layer stack may in particular be fin-shaped.

A material of the channel layers may be Si₁₋ₐGeₐ, a material of the liner layers may be Si_{1-b}Ge_{b}, the first sacrificial semiconductor material may be Si_{1-c}Ge_{c}, and the second sacrificial semiconductor material may be Si_{1-d}Ge_{d}, wherein 0 ≤ a ≤ b < d < c.

The channel layer may be formed of a channel material being Si₁₋ₐGeₐ. The channel material may be Si. As such, a may be equal to 0.

The liner layer may be formed of a layer material being Si_{1-b}Ge_{b}. The layer material may be Si. As such, b may be equal to 0.

The first sacrificial layer may be formed of a first sacrificial material being Si_{1-c}Ge_{c}.

The second sacrificial layer may be formed of a second sacrificial material being Si_{1-d}Ge_{d}.

The first and second sacrificial materials may be chosen such that c is greater than d. In other words, the Ge-content of the second sacrificial material may be smaller than that of the first sacrificial material. The first sacrificial layer may thus be said to be formed of a first sacrificial material having high Ge-content. In other words, layers adjacent to the channel layers may have high Ge-content. The second sacrificial layer may thus be said to be formed of a second material having low Ge-content. The second sub-stack may hence comprise a plurality of sacrificial layers alternating between having high and low Ge-content.

It may in this context be noted that terms high and low refer to the Ge-content of the first and second sacrificial layers relative to each other. Thus, even if the first sacrificial layer may have a high Ge-content relative to the second sacrificial layers, said Ge-content may still be lower than the Ge-content of high Ge-content layers in conventional structures. More specifically, the employment of inner spacers, liner layers, and the arrangement of the first sacrificial layers (having high Ge-content) relative to (i.e. arranging the first sacrificial layers in close proximity to or in abutment with) the channel layers enables the Ge-content of the first sacrificial layers of the invention to be lower than when the low Ge-content layers are arranged in proximity with or abutment with channels layers in conventional structures. Thus, the invention provides reduced selectivity requirements.

The employment of the liner layers separating the sacrificial layers and the inner spacers enables the second sacrificial layers to be subjected to removal and subsequently dielectric layers may instead replace said second sacrificial layers. As discussed above, the second sacrificial layers may be said to have low Ge-content. The first sacrificial layers may be said to have high Ge-content. It is a realization that the method may facilitate the formation of dielectric layers by removal of the second sacrificial layers having low Ge-content, and thereby an improved method may be provided. Also, the liner layers and the inner spacers may protect the SiGe-layers of high Ge-content during the act of removing the at least one SiGe-layer of low Ge-content.

As discussed above, the employment of liner layers and inner spacers enables the first and second sacrificial layers to be chosen to minimize lattice mismatch therebetween. That is, should the first sacrificial layer be formed of a first sacrificial material being Si_{1-c}Ge_{c} and the second sacrificial layer be formed of a second sacrificial material being Si_{1-d}Ge_{d}, c may be chosen to be greater than d while, simultaneously, the difference between c and d may be comparably small. Thus, it is a realization that the method may facilitate the use of a small difference in Ge-content between the high and low Ge-content sacrificial layers. Thus, there is provided a larger degree of design for the semiconductor structure. Furthermore, the reduced lattice mismatch between the sacrificial layers enables a superlattice growth of such layers with reduced risk for relaxation and reduced amount of epitaxial growth induced defects. Consequently, a semiconductor structure with e.g. reduced leakage current may be provided. In addition, the growth of a fully strained superlattice is enabled, which in turn provides for a semiconductor structure with improved device performance.

It is implied by the method that the respective channel layer of the first and third sub-stacks may be positioned next to a respective first sacrificial layer (SiGe-layer of high Ge-content). It is a realization that by placing the channel layers next to SiGe-layers of high Ge-content (rather than next to SiGe-layers of low Ge content), the strain distribution of the layer stack may be different (and advantageous) compared to a conventional layer stack. In other words, in such a conventional layer stack, the respective channel layer of the first and third sub-stacks is instead positioned next to a SiGe-layer of low Ge-content. Such an advantageous strain distribution may facilitate a low risk of dislocation formation during epitaxial growth of the layer stack compared to conventional methods and their associated semiconductor structures. Thus, higher quality FETs may be facilitated, e.g. FETs without dislocations in the channel layers.

It may in this context be noted that by placing the channel layers next to SiGe-layers of high Ge-content, the channel layers may abut said SiGe-layers of high Ge-content.

Further, said advantageous strain distribution may facilitate a large freedom of design for the semiconductor structure. For example, other layer thicknesses of the SiGe-layers, as compared to conventional devices may be enabled. It may e.g. be possible to make thicker MDIs than with a conventional structure.

The SiGe-layers may be used as sacrificial layers during production of the stack of FETs. The SiGe-layers of low Ge-content may, as described above, replaced by a dielectric material. Said dielectric material (dielectric layers) may be said to form middle dielectric isolation (MDI) in the end product. The SiGe-layers of high Ge-content may, in the end product, be replaced by a gate stack, such as a gate-all-around design or a tri-gate design.

It may in this context be noted that a difference in Ge-content between the sacrificial layers may be chosen in order to facilitate selective etching of the sacrificial layers. However, it is a realization that a too large difference in Ge-content results in a strain distribution which may lead to an increased risk for relaxation of the layer stack and thereby a greater amount of defects. The method thus provides an advantageous strain distribution as discussed above while still enabling selective etching.

The first sacrificial semiconductor material may have such a composition that c may be in a range of 0.25-0.35.

By way of example, c may be below 0.30. In general, by c being in the range of 0.25-0.35, there may be provided a fully strained superlattice growth of the sacrificial layers. The superlattice may also be grown with reduced risk for relaxation and reduced amount of epitaxial growth induced defects.

By way of a further example, the first sacrificial material may be Si_{0.75}Ge_{0.25}, and the second sacrificial material may be Si_{0.9}Ge_{0.1}. Such relative differences in Ge-content may facilitate a selective processing (e.g. selective etching) of the different sacrificial layers and the channel layers of the layer stack, while enabling a superlattice growth with reduced risk for relaxation and reduced amount of defects.

A thickness of the liner layers may be in a range of 1 nm to 3 nm.

By way of example, a thickness of the liner layers may be 1 nm, 2 nm, or 3 nm. By way of another example, a thickness of the liner layers may be below 2 nm, or below 3 nm. Such a thickness of the liner layers provides sufficient protection for the first sacrificial layers of the second sub-stack when removing the second sacrificial layers, while simultaneously providing a semiconductor structure being thin. This enables further device scaling. Also, a reduced growth thickness of the liner layers may enable a reduced amount of growth defects of the layer stack. The liner layers may be thin enough to prevent parasitic source and drain epitaxial growth.

Further, such a liner thickness may prevent diffusion of atoms throughout the layer stack during processing steps such as anneal, while still enabling a comparably thin semiconductor structure.

Forming the recesses may comprise isotropic selective etching of the end surfaces of the first sacrificial layers from opposite ends of the layer stack.

Isotropic etching of the end surfaces allows for a controlled formation of the recesses. As such, this facilitates subsequent processing steps e.g. the act of forming inner spacers in the recesses.

However, it is also conceivable that any suitable dry etching process or wet etching process allowing selective etching of the first sacrificial material may be used (e.g. HCl, or APM).

The second sub-stack may comprise at least two second sacrificial layers.

The method may accordingly comprise replacing each second sacrificial layer of the sub-stack with a respective dielectric layer by forming respective cavities in the second sub-stack by selectively etching the second sacrificial semiconductor material, and thereafter filling each cavity with dielectric material.

It is implied that the resulting semiconductor structure may hence comprise at least two dielectric layers arranged between the bottommost channel layer of the third sub-stack and the topmost channel layer of the first sub-stack. The employment of at least two second sacrificial layers as discussed above enables forming of a plurality of comparably thin dielectric layers, wherein each of said dielectric layer may be thinner than a single unit of a thick dielectric layer. A smaller thickness of the second sacrificial layers may facilitate the replacement thereof with the dielectric layers since the second sacrificial layers may be removed more quickly, thus reducing the exposure of the first sacrificial layers and the channel layers to the etchants. Also, the second sacrificial layers may have such a thickness that removal thereof enables dielectric material to be conformally deposited (e.g. by ALD) with a thickness sufficient to fill (and pinch-off). There may also be provided a semiconductor structure having a sufficiently thick separation between the first sub-stack and the third sub-stack. Also, the method may enable the formation of a layer stack with reduced risk for relaxation and reduced amount of growth defects. By the second sub-stack comprising at least two second sacrificial layers (and subsequently at least two dielectric layers) the channel(s) of the first sub-stack and the third sub-stack, respectively, may be sufficiently electrically isolated from each other.

As discussed above, it should be noted that the employment of liner material and the inner spacers (and the resulting less stringent selectivity requirements) may facilitate a large freedom of design for the semiconductor structure. Since it is thus possible to choose the sacrificial materials to reduce lattice mismatch therebetween, there is provided leeway to make thicker MDIs than with a conventional structure, while ensuring that the layer stack still does not suffer from relaxation. It is also conceivable that a single unit of a (thick) MDI may be formed rather than a plurality of (thinner) MDIs.

Filling the at least one first cavity with dielectric material may be performed by atomic layer deposition, ALD.

This enables forming high-quality dielectric layers.

The method may further comprise:
removing the first sacrificial layers of the layer stack, thereby forming second cavities;
forming a first gate stack extending around each channel layer of the first sub-stack;
forming a second gate stack extending around each channel layer of the third sub-stack;
wherein each of the first and second gate stack extends through the second cavities.

The method may accordingly comprise a gate for controlling a current in the top channel layer and the bottom channel layer.

The layer stack may further comprise a bottom second sacrificial layer arranged between the substrate and the first sub-stack, and a liner layer arranged between the bottom second sacrificial layer and the first sub-stack, and wherein the method further comprises:
removing the bottom second sacrificial layer arranged between the substrate and the first sub-stack by etching, thereby forming a bottom cavity;
filling the bottom cavity with dielectric material thereby forming a bottom dielectric layer.

The method may accordingly comprise a bottom dielectric layer that electrically isolates the layer stack from the substrate. Thus, leakage current may be reduced.

The act of removing the bottom second sacrificial layer arranged between the substrate and the first sub-stack may be performed simultaneous with the act of removing each second sacrificial layer of the second sub-stack.

The amount of processing steps of the method may accordingly be reduced. Thus, there is provided an efficient method of forming a semiconductor structure.

It is also implied that the bottom second sacrificial layer arranged between the substrate and the bottom channel layer may be formed of the second sacrificial material. That is, the bottom second sacrificial layer may be formed of Si_{1-d}Ge_{d}. Thus, the bottom second sacrificial layer may be removed simultaneous with the act of removing the second sacrificial layers of the second sub-stack with e.g. etching in a single step. When removing the second sacrificial layers by etching, the bottom second sacrificial layer may be exposed to the same etchant and be removed in the same rate. Thus, the bottom second sacrificial layer and the second sacrificial layers may be removed together. This obviates any potential issues with recessing residual layers in a further separate processing step. The method may also be made more efficient. This further also facilitates any subsequent processing steps, such as the formation of the dielectric layers.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

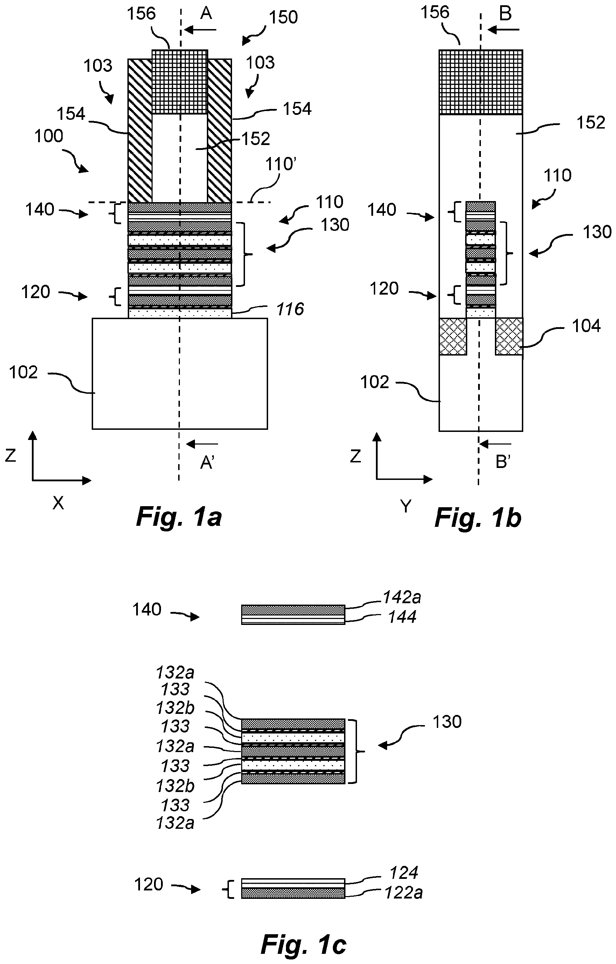

Figs. 1a-c to 12a-b illustrate the formation of the semiconductor structure formation of a method applied to a semiconductor device in a schematically depicted cross-sectional view.

### DETAILED DESCRIPTION

Figs. 1a-b depict a semiconductor structure 100 at an initial stage of a method for forming a resulting semiconductor device, in particular a stacked transistor device such as a CFET device.

Axes X, Y and Z indicate a first direction, a second direction transverse to the first direction, and a vertical or bottom-up/stacking direction, respectively. The X- and Y-direction may in particular be referred to as lateral or horizontal directions in that they are parallel to a main plane of a substrate 102 of the structure 100. The Z-direction is parallel to a normal direction to the substrate 102.

Figs. 1a-b depict respective cross-sectional views of the structure 100 taken along vertical planes B-B' (parallel to the XZ-plane) and A-A' (parallel to the YZ plane). The cross-sectional views of the subsequent figures correspond to those in Figs. 1a-b unless stated otherwise.

The structure 100 comprises a substrate 102 and a device layer stack 110 formed on the substrate 102. The substrate 102 may be a conventional semiconductor substrate suitable for complementary FETs. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The device layer stack 110 comprises a first sub-stack 120, a second sub-stack 130 on the first sub-stack 120, and a third sub-stack 140 on the second sub-stack 130.

Fig. 1c depicts the first sub-stack 120 (bottom), the second sub-stack 130 (middle) and the third sub-stack 140 (top) in isolation for illustrational clarity.

The first sub-stack 120 comprises a first sacrificial 122a and a channel layer 124 on the first sacrificial layer 122a. The channel layer 124 forms a top (i.e. topmost) layer of the first sub-stack 120. The layers 122a and 124 may be referred to as one unit of the first sub-stack 120. Although Fig. 1c depicts merely one such unit (i.e. a single) of the first sub-stack 120, it is to be understood that the first sub-stack 120 may comprise more than merely a single unit. For instance, the first sub-stack 120 may e.g. comprise two, three, or four etc. units. As such, the first sub-stack 120 may comprise two, three, or four etc. first sacrificial layers 122a and channel layers 124, respectively. In case the first sub-stack 120 comprises a plurality of such units, said units may be consecutively arranged. For instance, the units may be arranged on top of each other.

The second sub-stack 130 comprises a plurality of sacrificial layers alternating between first and second sacrificial layers 132a, 132b. Neighboring first and second sacrificial layers 132a, 132b of the second sub-stack 130 are separated by a liner layer 133. It may thus be said that the liner layer 133 may abut each first and second sacrificial layer 132a, 132b that it separates.

Fig. 1c illustrates a second sub-stack 130 comprising (along a bottom-up/stacking direction) a bottommost first sacrificial layer 132a, a liner layer 133, a second sacrificial layer 132b, a liner layer 133, a first sacrificial layer 132a, a liner layer 133, a second sacrificial layer 132b, a liner layer 133, and a topmost first sacrificial layer 132a. The bottommost first sacrificial layer 132 is thus arranged on the first sub-stack 120, i.e. on the channel layer 124. Although Fig. 1c depicts merely two second sacrificial layers 132b of the second sub-stack 130, it is to be understood that the second sub-stack 130 may comprise more than merely two second sacrificial layers 132b. It is also conceivable that the second sub-stack 130 may comprise one (i.e. a single) second sacrificial layer 132b.

The third sub-stack 140 comprises a channel layer 144 and a first sacrificial layer 142a on the channel layer 144. The channel layer 144 forms a bottom (i.e. bottom-most) layer of the third sub-stack 140. The channel layer 144 is thus arranged on the second sub-stack 130, i.e. on the topmost first sacrificial layer 132a. The layers 144 and 142a may be referred to as one unit of the third sub-stack 140. Although Fig. 1c depicts merely one such unit (i.e. a single) of the third sub-stack 140, it is to be understood that the third sub-stack 140 may comprise more than merely a single unit. For instance, the third sub-stack 140 may e.g. comprise two, three, or four etc. units. As such, the third sub-stack 140 may comprise two, three, or four etc. first sacrificial layers 142a and channel layers 144, respectively. In case the third sub-stack 140 comprises a plurality of such units, said units may be consecutively arranged. For instance, the units may be arranged on top of each other.

The first sacrificial layers of the first through third sub-stacks 120, 130, 140 (122a, 132a, 142a) and the second sacrificial layers of the second sub-stack 130 may be formed with a uniform or at least similar thickness. It is also conceivable that the second sacrificial layers may be formed with a greater thickness than each of the first sacrificial layers of the first through third sub-stacks 120, 130, 140 (122a, 132a, 142a). The total thickness of the second sub-stack 130 may accordingly exceed a thickness of each first sacrificial layer of the first sub-stack 120 and the third sub-stack 140.

The channel layers of the first and third sub-stacks 120, 140 may also be of a uniform or at least similar thickness, e.g. a different or a same thickness as the first sacrificial layers of the layer stack 110.

Each of the liner layers of the second sub-stack 130 may be of a uniform or at least similar thickness.

By way of example, the channel layers of the first and third sub-stacks 120, 140 may each be formed with a thickness of 3-10 nm, the first sacrificial layers of the first through third sub-stacks 120, 130, 140 (122a, 132a, 142a) may each be formed with a thickness of 3-10 nm, the second sacrificial layers 132b may be formed with a thickness of 5-30 nm, and the liner layers 133 may be formed with a thickness of 1-3 nm. The total thickness of the second sub-stack 130 may for example be 20-50 nm.

Each first sacrificial layer of the first through third sub-stacks 120, 130, 140 (122a, 132a, 142a) is formed of a same first sacrificial material.

The second sacrificial layer(s) 132b of the second sub-stack 130 is formed of a second sacrificial material different from the first sacrificial material. Each channel layer of the first and third sub-stacks 120, 140 (124, 144) is formed of a same channel material, different from each of the first and second sacrificial materials. The liner layers 133 are formed of a semiconductor material different from the first and second semiconductor materials.

For example, the channel material may be Si₁₋ₐGeₐ, the liner material may be Si_{1-b}Ge_{b}, the first sacrificial material may be Si_{1-c}Ge_{c}, and the second sacrificial material may be Si_{1-d}Ge_{d}, wherein 0 ≤ a≤ b < d < c. For example, c may be in a range of 0.25-0.35. In a more specific example, the channel material be Si, the first sacrificial material may be Si_{0.75}Ge_{0.25}, and the second sacrificial material may be Si_{0.9}Ge_{0.1}. These relative differences in Ge-content facilitate a selective processing (e.g. selective etching) of the different sacrificial layers and the channel layers of the layer stack 110, while enabling a superlattice growth with reduced risk for relaxation and reduced amount of defects.

The layers of the device layer stack 110 may each be epitaxial layers, e.g. epitaxially grown using deposition techniques which per se are known, such as chemical vapor deposition (CVD) or physical vapor deposition (PVD). This enables high quality material layers with an advantageous degree of control of composition and dimensions.

The deposited layers may be sequentially formed and subsequently patterned to define an elongated fin-shaped layer stack, extending in the X-direction. The dashed line 110' schematically indicates a contour of the layer stack 110 subsequent to fin patterning and prior to fin recess, described below. While the figures depict only a single layer stack, it is to be understood that a plurality of parallel fin-shaped layer stacks may be formed. Conventional fin patterning techniques may be used, e.g. single patterning techniques such as lithography and etching ("litho-etch") or multiple-patterning techniques such as LELE (litho-etch-litho-etch), (litho-etch)x, self-aligned double or quadruple patterning (SADP or SAQP).

The layers of the layer stack 110 may each be formed as nanosheets, e.g. with a width (along Y) to thickness (along Z) ratio greater than 1, such as a width in a range from 10 nm to 30 nm and a thickness in a range from 3 nm to 10 nm. It is also possible to pattern the layer stacks such that the channel layers form nanowire-shaped layers. A nanowire may by way of example have a thickness similar to the example nanosheet however with a smaller width, such as 3 nm to 10 nm.

As shown in Figs. 1a-b, subsequent to the fin patterning, a lower portion of the device layer stack 110 may be surrounded by a shallow trench isolation (STI) 104, e.g. of SiO₂.

As further shown in Figs. 1a-b, a sacrificial gate structure 150 may be formed to extend across the layer stack 110. The sacrificial gate structure 150 comprises a sacrificial gate body 152. The sacrificial gate body 152 may be formed by depositing a sacrificial gate body material (e.g. amorphous Si) over the layer stack 110 and subsequently patterning the sacrificial gate body 152 therein. While the figures depict only a sacrificial gate structure 150, it is to be understood that a plurality of parallel sacrificial gate structures may be formed across the layer stack 110. Conventional patterning techniques may be used, e.g. single patterning techniques such as lithography and etching ("litho-etch") or multiple-patterning techniques such as (litho-etch)x, SADP or SAQP.

The sacrificial gate structure 150 further comprises a first spacer or first spacer layer 154 on opposite sides of the sacrificial gate body 152. The first spacer 154 may also be referred to as gate spacer 154. The gate spacer 154 may be formed by conformally depositing a gate spacer material and subsequently anisotropically etching the gate spacer material (e.g. top-down) to remove portions of the gate spacer material from horizontally oriented surfaces of the structure 100 and such that portions of the gate spacer material remain on the side surfaces of the sacrificial gate body 152 to form the gate spacer 154. The gate spacer 154 may be formed of dielectric material, e.g. as an oxide, a nitride or a carbide such as SiN, SiC, SiCO, SiCN or SiBCN deposited by ALD.

The sacrificial gate structure 150 may as shown further comprise a capping layer 156, e.g. formed of one or more layers of hardmask material remaining from the sacrificial gate body patterning.

After forming the sacrificial gate structure 150 the device layer stack 110 may be recessed by etching back the device layer stack 110 in a top down direction (e.g. negative Z) while using the sacrificial gate structure 150 as an etch mask. The etching may extend through each of the third, second and first sub-stacks 140, 130, 120 such that portions of each layer thereof are preserved underneath the sacrificial gate structure 150, as shown in Fig. 1a.

As indicated in Fig. 1a, etching back the device layer stack 110 has formed recesses 103 in the layer stack 110. A respective recess 103 may be formed in the layer stack 110 at opposite sides of the layer stack 110.

As will be apparent from the following, each of the first sacrificial layers of the first through third sub-stacks 120, 130, 140 (122a, 132a, 142a) will be subjected to the same process steps. Hence, for brevity, these layers will in the following be commonly denoted the first sacrificial layers of the device layer stack 110, or of the first sub-stack 120, the second sub-stack 130 or the third sub-stack. For corresponding reasons, the channel layers of the first and third sub-stacks 120, 140 (124, 144) may in the following be commonly denoted the channel layers of the layer stack 110, or of the first sub-stack 120 or the third sub-stack 140.

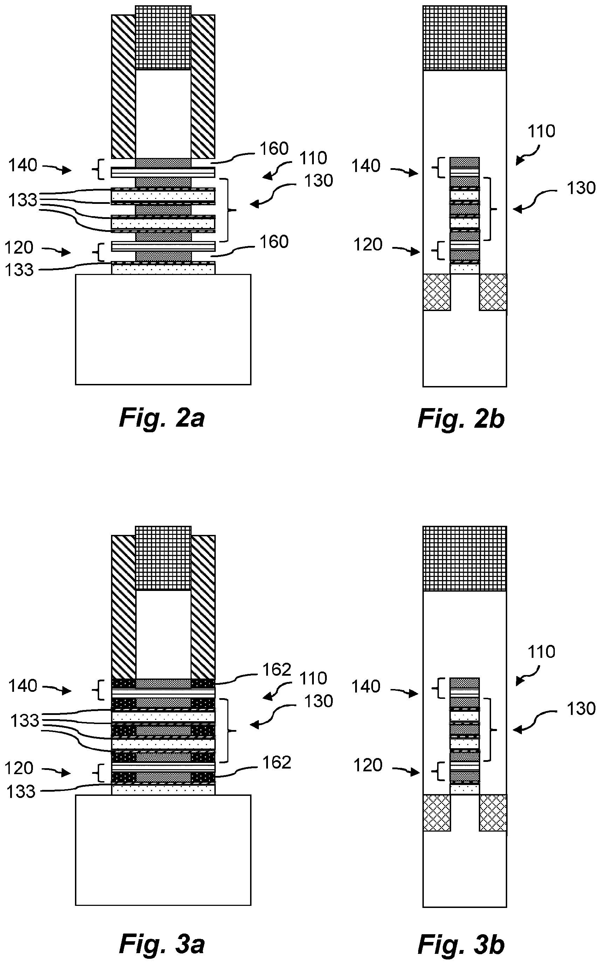

Fig. 2a-b show processing steps for forming inner spacers 162.

In Fig. 2a, recesses 160 have been formed in the layer stack 110 by laterally etching back (e.g. along the X- and negative X-direction) end surfaces of each first sacrificial layer of the layer stack 110 from opposite ends of the layer stack 110, by selective etching. The lateral etch back may be achieved by an isotropic etching process. Any suitable dry etching process or wet etching process allowing selective etching of the first sacrificial material may be used (e.g. HCl, or APM). As indicated in Fig. 2a, the extent of the lateral etch back may correspond to a thickness of the gate spacer 154. In other words, a depth of the recesses 160 (e.g. along the X-direction) may correspond to the thickness of the gate spacer 154 (along the X-direction).

In Fig. 3a, the recesses 160 have been filled with one or more conformally deposited inner spacer materials. Examples of inner spacer materials include conformally deposited dielectric materials, e.g. as an oxide, a nitride or a carbide, for example SiN deposited by ALD. In one example, a single inner spacer material (e.g. SiN) may be deposited to fill the recesses 160. In another example, a first inner spacer material (e.g. SiOC) may be deposited to partially fill the recesses 160 wherein a second inner spacer material (e.g. SiN) may be deposited to fill (by pinch-off) a remaining space in the recesses 160.

As further shown in Fig. 3a, the inner spacers 162 have been formed in the recesses 160 by subjecting the inner spacer material to an isotropic etching process to remove portions of the inner spacer material deposited outside the recesses 160. Any suitable isotropic etching process (wet or dry) for etching the dielectric material (e.g. SiN or SiN and SiOC) may be used. The etching may as shown be stopped when end surfaces of the channel layers of the layer stack 110 are exposed and discrete portions of the inner spacer material remain in the recesses 160 to form the inner spacers 162.

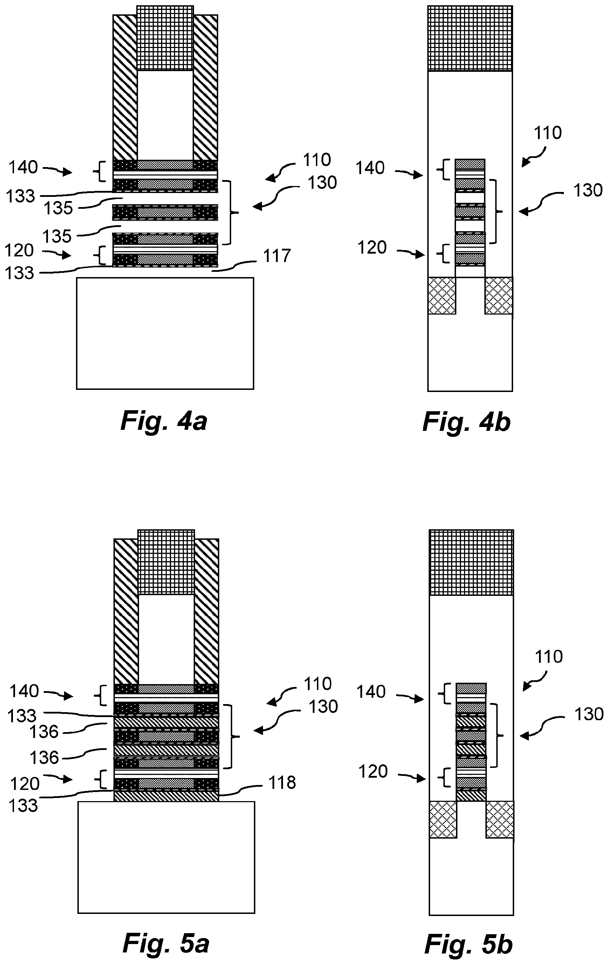

Figs. 4a-b show process steps for replacing the second sacrificial layers 132b of the second sub-stack 130 with a respective dielectric layer 136.

In Fig. 4a the second sacrificial layers 132b of the second sub-stack 130 have been removed by selectively etching the second sacrificial semiconductor material, thereby forming a cavity 135 in the second sub-stack 130. The second sacrificial semiconductor material may be etched using an isotropic etching process (wet or dry), to laterally etch back end surfaces of the second sacrificial layers 132b from opposite sides of the layer stack 110. For example, an HCl-based dry etch may be used to remove second sacrificial layer material having smaller Ge-content than that of the first sacrificial material. However, other appropriate etching processes (e.g. wet etching processes) are also known in the art and may also be employed for this purpose.

In Fig. 5a-b the cavities 135 have been filled with a dielectric material, e.g. a nitride such as SiN. The dielectric material may be conformally deposited (e.g. by ALD) with a thickness sufficient to fill (and pinch-off) the respective cavity 135. Examples of a dielectric material include SiO2, Si3N4, SiCO, SiOCN, SiON, SiCN, SiC, SiBCN, and SiBCNO.

The dielectric material has been subjected to an isotropic etching process to remove portions of the dielectric material deposited outside the respective cavity 135. Any suitable isotropic etching process (wet or dry) for etching the dielectric material (e.g. SiN) may be used. The dielectric material remaining in the respective cavity 135 forms the respective dielectric layer 136.

As discussed above, although Fig. 1c depicts two second sacrificial layers 132b of the second sub-stack 130, it is to be understood that the second sub-stack 130 may comprise more than merely two second sacrificial layers 132b. It is also conceivable that the second sub-stack 130 may comprise one (i.e. a single) second sacrificial layer 132b. Thus, subsequent processing steps may involve forming at least one dielectric layer 136.

As shown in Fig. 1a, the layer stack 110 may also comprise a bottom second sacrificial layer 116. The bottom second sacrificial layer 116 may be arranged between the substrate 102 and the first sub-stack 120. A liner layer 133 may also be arranged between the bottom second sacrificial layer 116 and the first sub-stack 120. Said liner layer 133 may separate the bottom second sacrificial layer 116 from the first sub-stack 120. The liner layer 133 may abut the bottom second sacrificial layer 116 and the first sacrificial layer 122a of the first sub-stack 120.

The bottom second sacrificial layer 116 may be subject to the same processing steps as the second sacrificial layers 132b of the second sub-stack 130.

In Fig. 4a, the bottom second sacrificial layer 116 arranged between the substrate 102 and the bottom channel layer 112 has been removed by etching, thereby forming a bottom cavity 117. The bottom second sacrificial semiconductor material may be etched using an isotropic etching process (wet or dry), to laterally etch back end surfaces of the bottom second sacrificial layer 116 from opposite sides of the layer stack 110. For example, an HCl-based dry etch may be used to remove bottom second sacrificial layer material having smaller Ge-content than that of the first sacrificial material. However, other appropriate etching processes (e.g. wet etching processes) are also known in the art and may also be employed for this purpose.

In Fig. 5a the bottom cavity 117 has been filled with a dielectric material, e.g. a nitride such as SiN. The dielectric material may be conformally deposited (e.g. by ALD) with a thickness sufficient to fill (and pinch-off) the bottom cavity 117. Examples of a dielectric material include SiO2, Si3N4, SiCO, SiOCN, SiON, SiCN, SiC, SiBCN, and SiBCNO.

The dielectric material has been subjected to an isotropic etching process to remove portions of the dielectric material deposited outside the bottom cavity 117. Any suitable isotropic etching process (wet or dry) for etching the dielectric material (e.g. SiN) may be used. The dielectric material remaining in the bottom cavity 117 forms the dielectric layer 118.

The bottom second sacrificial layer 116 may be formed of the same sacrificial material as the second sacrificial material. That is, the bottom second sacrificial layer 116 may be formed of Si_{1-d}Ge_{d}. In a more specific example, should the second sacrificial layers 132b be of Si_{0.9}Ge_{0.1}, then the second sacrificial layer 116 may also be of Si_{0.9}Ge_{0.1}.

The act of removing the bottom second sacrificial layer 116 may be performed simultaneous with the act of removing the at least one second sacrificial layer 132b of the layer stack 110.

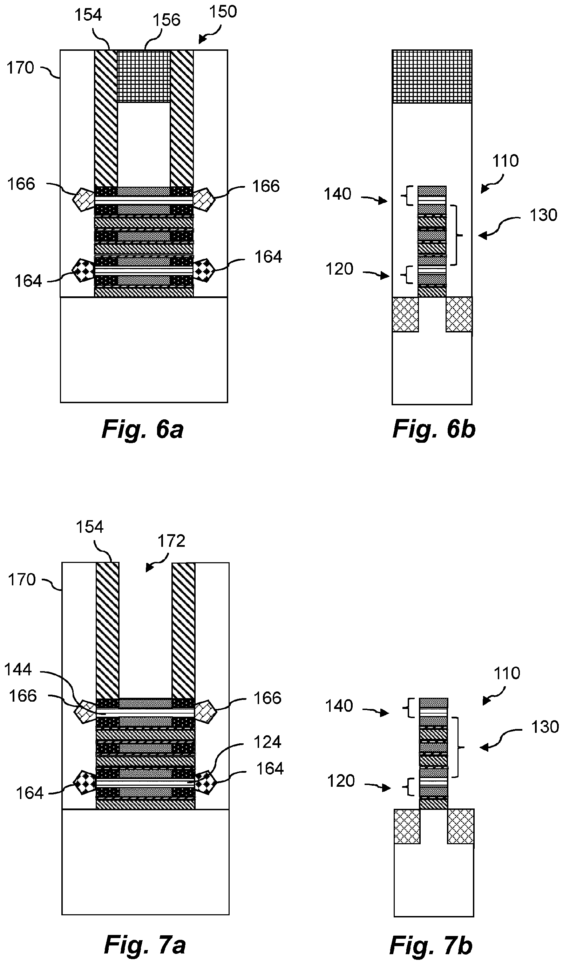

In Figs. 6a-b, source and drain regions 164 and 166 have been formed on the channel layer(s) of the first sub-stack 120 and the third sub-stack 140, respectively. The source and drain regions 164, 166 have been formed by epitaxially growing semiconductor material on end surfaces of the channel layers exposed at opposite sides of the sacrificial gate structure 150.

The source and drain regions 164 formed on the channel layer end surfaces of the first sub-stack 120 may be of a first conductivity type and the source and drain regions 166 formed on the channel layer end surfaces of the third sub-stack 140 may be of a second opposite conductive type. The first and second conductivity types may be a p-type and an n-type, or vice versa. The doping may be achieved by in-situ doping. Different conductivity types of the source and drain regions 164 and the source and drain regions 166 may be achieved by masking the channel layer end surfaces of the third sub-stack 140 while performing epitaxy on the channel layer end surfaces of the first sub-stack 120. The masking of the channel layer end surfaces of the third sub-stack 140 may for example be provided by forming a temporary cover spacer along the third sub-stack 140. After completing the epitaxy of the source and drain regions 164, the temporary cover spacer may be removed and the source and drain regions 164 may be covered with one or more dielectric materials (e.g. ALD-deposited SiN and an inter-layer dielectric like SiO₂). Epitaxy may then be performed on the channel layer end surfaces of the third sub-stack 140. This is however merely one example and other process techniques facilitating forming of the source and drain regions 164, 166 with different conductivity types may also be used.

The source and drain regions 164, 166 may as shown subsequently be covered by an insulating layer 170. The insulating layer 170 may be formed of an insulating material, such as an oxide, e.g. SiO₂, or another inter-layer dielectric, deposited, planarized and recessed, e.g. by chemical mechanical polishing (CMP) and/or etch back. The CMP and/or etch back may proceed to also remove any capping 156 of the sacrificial gate structure 150. It is however also possible to stop the CMP and/or etch back on the capping 156 and subsequently open the capping using a separate etch step.

In Figs. 7a-b a gate trench 172 has been formed by removing the sacrificial gate body 152 between the opposite gate spacers 154. Any conventional suitable etching process (isotropic or anisotropic, wet or dry) allowing selective removal of the sacrificial gate body 152 (e.g. of amorphous Si) may be used.

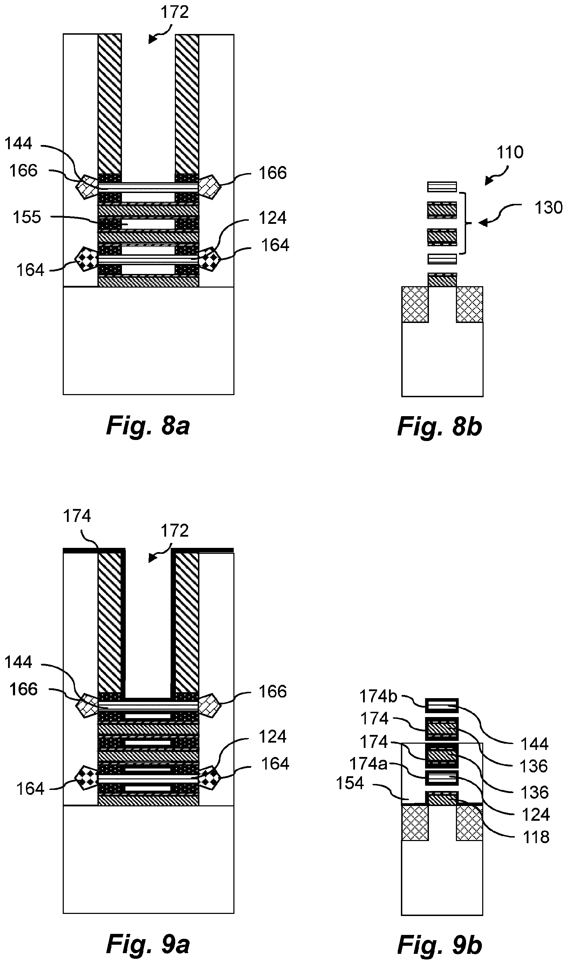

In Figs. 8a-b the first sacrificial layers of the device layer stack 110 have been removed by selectively etching the first sacrificial semiconductor material from the gate trench 172. A same type of etching process may be used for this step as during the forming of the recesses 160. By removing the first sacrificial layers, the channel layers of the device layer stack 110 may be released in the sense that upper and lower surfaces thereof may be exposed within the gate trench 172. Thus, second cavities 155 are formed. As the dielectric layer 154 prior to this process step was surrounded by first dielectric layers (e.g. the first dielectric layer 132a and the second dielectric layer 132b of the second sub-stack 130), also the dielectric layer 154 is released.

Figs. 9a-b to Figs. 12a-b illustrate process steps for forming a gate stack 180 surrounding the released channel layers and the dielectric layers 136 in the gate trench 172.

In Figs. 9a-b, a gate dielectric layer and then a first gate work function metal (WFM) 174 have been conformally deposited in the gate trench 172. The gate dielectric layer is for illustrational clarity not individually shown in the figures but its coverage may correspond with that indicated for layer 174. The gate dielectric layer may be formed of a conventional a high-k dielectric e.g. HfO2, HfSiO, LaO, AlO or ZrO. The first WFM 174 may be formed of one or more effective WFMs (e.g. an n-type WFM such as TiAl or TiAlC and/or a p-type WFM such as TiN or TaN). The gate dielectric layer and the first WFM may be deposited by ALD.

As further shown in Fig. 9b, a block mask 154 may subsequently be formed in a lower part of the gate trench 172. The block mask 154 may be formed a thickness (e.g. along the Z-direction) such that the portions of the first WFM 174 surrounding the channel layers of the first sub-stack 120 (e.g. portion 174a surrounding the channel layer 124) is covered and the portions of the first WFM 174 surrounding the channel layers 144 of the third sub-stack 140 (e.g. the portion 174b surrounding the channel layer 144) are exposed.

The block mask 154 may be formed by depositing a block mask material filling the gate trench 172. The block mask material may e.g. be spin-on-carbon or another organic spin-on material. The block mask material may subsequently be etched back top-down (e.g. using an anisotropic etch) to a target level. The target level may as shown be located between the dielectric layers 136. The portions of the first WFM 174 surrounding the channel layers of the third sub-stack 140 may thus be exposed.

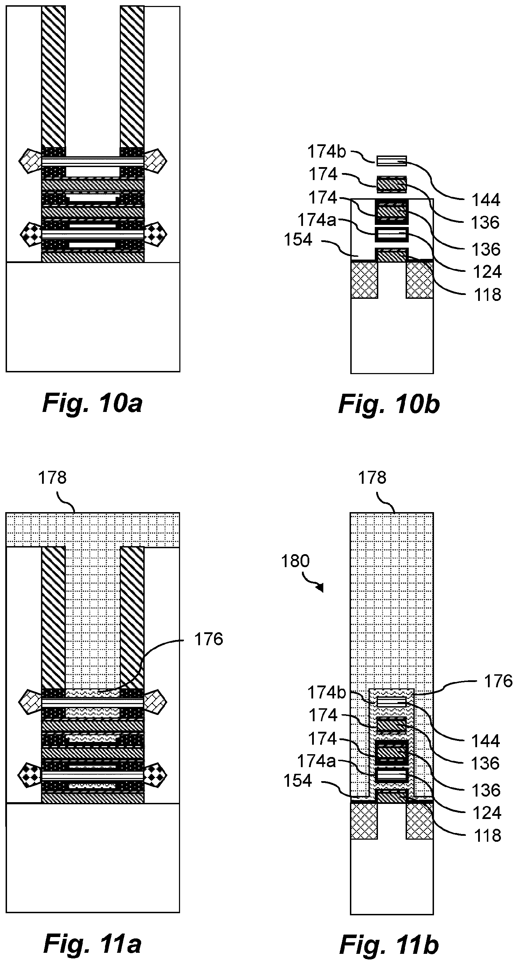

In Figs. 10a-b, the first WFM 174 has been removed from the channel layer(s) of the third sub-stack 140 while using the block mask 154 as an etch mask. Depending on the particular thickness of the block mask 154, at least a portion of the first WFM 174 surrounding the dielectric layers 136 may also be removed. The first WFM 174 surrounding the channel layer(s) to the first sub-stack 120 (e.g. the portion 174a surrounding the channel layer 124) may however be preserved, due to the block mask 154.

The first WFM 174 may be removed using a suitable isotropic (wet or dry) etch, allowing selective removal of the first WFM 174 without removing the gate dielectric. Subsequently, the block mask 154 may be removed from the trench 172.

In Figs. 11a-b, a second gate WFM 176 has been conformally deposited in the gate trench 172. The second WFM 176 may be deposited on the gate dielectric surrounding the channel layer(s) of the third sub-stack 140, and on portions of the gate dielectric exposed on the liner layers 133/dielectric layers 136. The second WFM 176 may thus surround the channel layer(s) of the third sub-stack 140. As shown in Figs. 11a-b, the second gate WFM 176 may further be deposited on the first WFM 174 surrounding the channel layer(s) of the first sub-stack 140.

The first WFM 174 may form a first gate stack. The second gate WFM 176 may for a second gate stack. Each of the first and second gate stacks may extend through the second cavities 155.

Subsequently, a gate fill metal 178 (such as W, Al, Co or Ru) may be deposited to fill a remaining space of the gate trench 172. The gate fill metal 178 may for instance be deposited by CVD or PVD.

Reference sign 180 indicates the full gate stack, comprising a lower portion comprising the gate dielectric layer, the first WFM 174, the second WFM 176 and the gate fill metal 178 surrounding the channel layer(s) of the first sub-stack 110, and an upper portion comprising the gate dielectric, the second WFM 176 and the gate fill metal 178 surrounding the channel layer(s) of the third sub-stack 140.

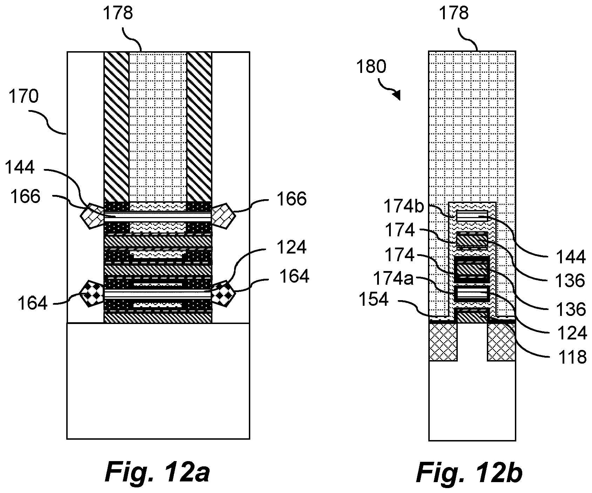

Figs. 12a-b depicts the resulting device structure 100 subsequent to a gate metal recess to bring a top surface of the gate stack 180 flush with an upper surface of the gate spacers 154.

The device structure 100 comprises a bottom device comprising the channel layer(s) of the first sub-stack 120, extending between the source and drain regions 164, and the lower portion of the gate stack 180. The device structure 100 further comprises a bottom device comprising the channel layer(s) of the third sub-stack 140, extending between the source and drain regions 166, and the upper portion of the gate stack 180. The dielectric layers 136 remain as electrically inactive dummy channels, between the channel(s) of the bottom device and the top device and surrounded by the gate stack 180.

The method may thereafter proceed with forming source/drain contacts by etching contact trenches in the insulating layer 170 and depositing one or more contact metals in the trenches, on the source and drain regions 164, 166. Separate contacting of the source and drain regions of the bottom device and the top device may be achieved by a first contact metal deposition over the source and drain regions 164, 166, etch back of the contact metal to a level between the source and drain regions 164 and 166, thus exposing the source and drain regions 164, 166, deposition of an insulating contact separation layer on the etched back contact metal, and subsequently a second contact metal deposition over the source and drain regions 166. Separate source and drain contacting may be applied to either or both sides of the semiconductor structure 100.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor structure (100), the method comprising:
forming a layer stack (110) on a substrate (102), the layer stack (110) comprising:
a first sub-stack (120) comprising a first sacrificial layer (122a) and on the first sacrificial layer (122a) a channel layer (124) defining a topmost layer of the first sub-stack (120),
a second sub-stack (130) on the first sub-stack (120) and comprising a plurality of sacrificial layers alternating between first and second sacrificial layers (132a, 132b), wherein neighboring first and second sacrificial layers (132a, 132b) of the second sub-stack (130) are separated by a liner layer (133), wherein first sacrificial layers (132a) define a respective bottommost and topmost layer of the second sub-stack (130), the second sub-stack (130) comprising at least one second sacrificial layer (132b);
a third sub-stack (140) on the second sub-stack (130) and comprising a channel layer (144) defining a bottommost layer of the third sub-stack (140) and a first sacrificial layer (142a) on the channel layer (144);
wherein the first sacrificial layers (122a, 132a, 144a) are formed of a first sacrificial semiconductor material, the second sacrificial layers (132b) are formed of a second sacrificial semiconductor material different from the first sacrificial semiconductor material, and the liner layers (133) are formed of a semiconductor material different from the first and second sacrificial semiconductor materials;
forming source/drain recesses (103), the source/drain recesses exposing end surfaces of the layer stack (110);
forming recesses (160) in the layer stack (110) by laterally etching back the end surfaces of the first sacrificial layers (122a, 132a, 142a) from opposite ends of the layer stack (110), by selective etching;
forming inner spacers (162) in the recesses (160);
removing the at least one second sacrificial layer (132b) of the second sub-stack (130) by etching, thereby forming at least one first cavity (135), while first sacrificial layers (132a) of the second sub-stack (130) are being protected from said act of etching by the inner spacers (162) and the liner layers (133); and
filling the at least one first cavity (135) with dielectric material thereby forming at least one dielectric layer (136).

2. The method according to claim 1, wherein a material of the channel layers is Si₁₋ₐGeₐ, a material of the liner layers is Si_{1-b}Ge_{b}, the first sacrificial semiconductor material is Si_{1-c}Ge_{c}, and the second sacrificial semiconductor material is Si_{1-d}Ge_{d}, wherein 0 ≤ a≤ b < d < c.

3. The method according to claim 2, wherein c is in a range of 0.25-0.35.

4. The method according to any one of the preceding claims, wherein a thickness of the liner layers (133) is in a range of 1 nm to 3 nm.

5. The method according to any one of the preceding claims, wherein forming the recesses (160) comprises isotropic selective etching of the end surfaces of the first sacrificial layers (122a, 132a, 142a) from opposite ends of the layer stack (110).

6. The method according to any one of the preceding claims, wherein the second sub-stack (130) comprises at least two second sacrificial layers (132b).

7. The method according to any one of the preceding claims, wherein filling the at least one first cavity (135) with dielectric material is performed by atomic layer deposition, ALD.

8. The method according to any one of the preceding claims, further comprising:
removing the first sacrificial layers (122a, 132a, 144a) of the layer stack (110), thereby forming second cavities (155);
forming a first gate stack extending around each channel layer of the first sub-stack (120);
forming a second gate stack extending around each channel layer of the third sub-stack (140);
wherein each of the first and second gate stack extends through the second cavities (155).

9. The method according to any one of the preceding claims, wherein the layer stack (110) further comprises a bottom second sacrificial layer (116) arranged between the substrate (102) and the first sub-stack (120), and a liner layer (133) arranged between the bottom second sacrificial layer (116) and the first sub-stack (120), and wherein the method further comprises:
removing the bottom second sacrificial layer (116) arranged between the substrate (102) and the first sub-stack (120) by etching, thereby forming a bottom cavity (117);
filling the bottom cavity (117) with dielectric material thereby forming a bottom dielectric layer (118).

10. The method according to claim 9, wherein the act of removing the bottom second sacrificial layer (116) arranged between the substrate (102) and the first sub-stack (120) is performed simultaneous with the act of removing each second sacrificial layer (132b) of the second sub-stack (130).
